# EUROPÄISCHE PATENTSCHRIFT

(11) **EP 4 449 138 B1**
(45) Veröffentlichungstag und Bekanntmachung des Hinweises auf die Patenterteilung: **25.02.2026**
(21) Anmeldenummer: 22809056.9
(22) Anmeldetag: 24.10.2022
(51) Int. Cl.: G01R 31/34, G01K 15/00

(54) **VERFAHREN UND VORRICHTUNG ZUM PLAUSIBILISIEREN EINER TEMPERATUR IN EINER KOMPONENTE EINER ELEKTRISCHEN MASCHINE IN EINEM TECHNISCHEN SYSTEM**
METHOD AND DEVICE FOR CHECKING THE PLAUSIBILITY OF A TERMPERATURE IN A COMPONENT OF AN ELECTRICAL MACHINE IN A TECHNICAL SYSTEM
PROCÉDÉ ET DISPOSITIF DE CONTRÔLE DE PLAUSIBILITÉ D'UNE TEMPÉRATURE DANS UN COMPOSANT D'UNE MACHINE ÉLECTRIQUE DANS UN SYSTÈME TECHNIQUE

(30) Priorität: 16.12.2021 DE 102021214526
(43) Veröffentlichungstag der Anmeldung: 23.10.2024
(73) Patentinhaber: Robert Bosch GmbH, 70442 Stuttgart (DE)
(72) Erfinder: HILALI, Wael, 70565 Stuttgart (DE); WOLL, Christoph, 70839 Gerlingen (DE)
(86) Internationale Anmeldenummer: PCT/EP2022/079573
(87) Internationale Veröffentlichungsnummer: WO 2023/110205

(56) Entgegenhaltungen:
- US-B2- 7 908 893

## Beschreibung

### Technisches Gebiet

Die Erfindung betrifft elektrische Maschinen für elektrische Antriebssysteme, insbesondere Verfahren zum Plausibilisieren einer Temperaturmessung eines Temperatursensors in einer Komponente der elektrischen Maschine.

### Technischer Hintergrund

Beim Betrieb von Elektromotoren entsteht durch Stromflüsse in Stator- und/oder Rotorspulen Verlustleistung, die zu einem Erwärmen von Komponenten des Elektromotors führt. Die Wärmeentwicklung ist dabei u. a. abhängig von dem in den Elektromotor fließenden Motorstrom bzw. der darin umgesetzten Leistung. Ein Überhitzen von Komponenten des Elektromotors kann zu Schädigungen oder Zerstörung von Spulenkomponenten führen und kann die Leistungsfähigkeit des Elektromotors aufgrund der Beeinträchtigung der Magnetfeldstärke (Demagnetisierung) von hart- und weichmagnetischen Komponenten reduzieren.

Die Wärmeentwicklung eines Elektromotors wird daher im Betrieb überwacht und eine Überhitzung durch ein Begrenzen des Motormoments, d. h. durch ein Begrenzen der Stromaufnahme, vermieden.

Herkömmliche Lösungen sehen das Anordnen eines oder mehrerer Temperatursensoren, in der Regel als temperaturempfindliche Widerstände, wie beispielsweise NTC-(Negative Thermal Coefficient-)Sensoren, an Statorspulen vor. Diese messen eine Temperatur an einer bestimmten Stelle des Stators, die gewöhnlich jedoch nicht einer maximalen oder repräsentativen Temperatur in dem Elektromotor entspricht, da die Position, an der die maximale Temperatur auftritt, von der bzw. den Positionen der Temperatursensoren abweicht.

Temperaturen in beweglichen Komponenten des Elektromotors, wie z. B. dem Rotor, werden derzeit mittels einer physikalischen Modellierung bestimmt, die jedoch in der Regel nicht alle thermischen Quellen oder Senken berücksichtigen kann. Zudem müssen die modellierten Wärmeverlustterme mit sehr aufwendigen Simulations- und/oder Prüfstandsmessungen bestimmt bzw. kalibriert werden.

Elektromotoren als elektrische Maschinen werden derzeit sowohl als Antriebsmotoren als auch als Stellmotoren für Fahrzeuge, Arbeitsmaschinen und als Stellmotoren eingesetzt.

Da die Temperaturbestimmung für Komponenten der elektrischen Maschine mithilfe eines Temperatursensors zur Vermeidung einer Schädigung oder Zerstörung der elektrischen Maschine wesentlich ist, ist eine Überwachung der ordnungsgemäßen Funktion des Temperatursensors erforderlich. Einfache Verfahren zur Plausibilisierung des Temperatursensorsignals werden bereits herkömmlich implementiert, wobei insbesondere die Überwachung einer Temperaturänderung innerhalb einer bestimmten Zeit oder unplausible hohe oder niedrige Temperaturwerte für eine Anomalieerkennung verwendet werden. Andere Verfahren zur Plausibilisierung des Sensorwerts des Temperatursensors sehen die Überwachung einer Kühlmitteltemperatur vor.

Die Überwachung eines Messwerts des Temperatursensors mithilfe eines virtuellen Sensors, der mit einem vollständigen physikalischen Temperaturmodell implementiert sein kann, ist sehr aufwendig und erfordert einen hohen Rechenaufwand, insbesondere wenn maschinelle Lernverfahren verwendet werden.

Die Druckschrift US 7,908,893 B2 offenbart ein Motorsystem, umfassend einen Motor mit einer erregbaren Wicklung, einen mit der Wicklung verbundenen Motorantrieb, eine mit dem Motorantrieb verbundene Temperaturmessvorrichtung und einen Prozessor, der so programmiert ist, dass er einen Temperaturkalibrierungsparameter auf der Grundlage der Temperatur des Motorantriebs und eines ersten Widerstandswerts der Wicklung bestimmt. Der Prozessor bestimmt einen Temperaturwert des Motors auf der Grundlage des Kalibrierungsparameters und eines zweiten Widerstandswerts der Wicklung.

### Offenbarung der Erfindung

Erfindungsgemäß sind ein Verfahren zum Plausibilisieren einer Temperaturmessung mit einem Temperatursensor in einer Komponente eines Elektromotors gemäß Anspruch 1 sowie eine Vorrichtung und ein Motorsystem gemäß den nebengeordneten Ansprüchen vorgesehen.

Weitere Ausgestaltungen sind in den abhängigen Ansprüchen angegeben.

Gemäß einem ersten Aspekt ist ein Verfahren zum Plausibilisieren einer Temperaturmessung eines Temperatursensors an einer Komponente einer elektrischen Maschine vorgesehen, mit folgenden Schritten:
- Überwachen eines Stroms in der elektrischen Maschine;
- bei Feststellen eines Betriebs mit stationärer Last, Bereitstellen eines ersten Temperaturmesswerts einer Temperatur der Komponente der elektrischen Maschine, der Zeitdauer des Betriebs mit stationärer Last und einer Umgebungstemperatur;
- Erfassen eines zweiten Temperaturmesswerts zu einem Ende des Betriebs mit stationärer Last;
- Bestimmen eines modellierten Temperaturwerts mithilfe eines datenbasierten Temperaturmodells abhängig von dem ersten Temperaturmesswert, der Zeitdauer und der Umgebungstemperatur, wobei das Temperaturmodell trainiert ist, um den ersten Temperaturmesswert, die Zeitdauer und die Umgebungstemperatur einem modellierten Temperaturwert zuzuordnen;
- Plausibilisieren des zweiten Temperaturmesswerts mit dem modellierten Temperaturwert.

Ein Betrieb mit stationärer Last wird festgestellt, wenn ein Strom in oder aus der elektrischen Maschine für eine vorbestimmte Mindestzeitdauer und für eine vorbestimmte Maximalzeitdauer konstant ist oder um nicht mehr als einem vorbestimmten Toleranzbetrag von einem Mittelwert des Stroms während der Zeitdauer abweicht.

Es kann vorgesehen sein, dass überprüft wird, dass die Zeitdauer des stationären Falls ausreichend groß ist, so dass ein signifikanter Temperaturunterschied zur Erkennung einer Signaldrift ausgewertet werden kann. Insbesondere kann bei Auftreten eines unplausiblen Temperaturwerts dieser entsprechend signalisiert werden, insbesondere durch ein optisches oder akustisches Signal, und/oder die Betriebsart der elektrischen Maschine kann entsprechend durch Leistungsreduzierung angepasst werden, um ein Überhitzen der Komponente der elektrischen Maschine zu vermeiden.

Zur Überwachung eines in einer Komponente einer elektrischen Maschine, wie z. B einem Stator oder einem Rotor, eingebauten Temperatursensors schlägt das obige Verfahren ein Temperaturmodell vor, das bei einem statischen Betriebszustand der elektrischen Maschine anwendbar ist. Im Normalbetrieb wird der Temperatursensor kontinuierlich überwacht und ermöglicht so eine rechtzeitige Leistungsreduzierung bzw. ein Derating, um eine Entmagnetisierung von Komponenten der elektrischen Maschine zu vermeiden.

Häufig kommt es jedoch im Laufe der Betriebsdauer eines Temperatursensors zu einer Signaldrift, so dass das Sensorsignal träge wird und es so zu einer Abweichung zwischen einer gemessenen Temperatur und einer tatsächlichen Temperatur kommt. Auch der umgekehrte Fall, dass das Temperatursensorsignal sich stärker verändert als die tatsächliche Temperatur, tritt gelegentlich auf.

Zur Plausibilisierung einer Temperaturmessung mit einem Temperatursensor wird entsprechend obigem Verfahren vorgeschlagen, ein Temperaturmodell zur Verfügung zu stellen, das das Temperaturverhalten einer Komponente einer elektrischen Maschine für einen statischen Betriebsfall modelliert. Insbesondere kann das Temperaturmodell eine Temperaturänderung für eine Zeitdauer eines stationären Zustands, während der die elektrische Maschine stromlos ist oder mit einer konstanten Last beaufschlagt ist, beschreiben.

Das Temperaturmodell kann als datenbasiertes Modell z.B. in einem Steuergerät als Software oder Hardware implementiert sein und abhängig von einem ersten gemessenen Temperaturwert einer aktuellen Komponententemperatur zu Beginn eines stationären Zustandes der elektrischen Maschine, einer Umgebungstemperatur und der Zeitdauer des stationären Zustands einen Temperaturwert am Ende der Zeitdauer des stationären Zustands modellieren. Das Temperaturmodell kann abhängig von Labormessungen der Temperaturmessung zum Ende der Zeitdauer des stationären Zustands trainiert sein. Ein so modelliertes Temperaturmodell umgeht die Problematik einer exakten Temperaturbestimmung durch ein geeignetes physikalisches, auf einem Zeitintegrationsverfahren basierenden Modell mit dynamischen und hochdynamischen Lastphasen, da der zeitlich verzögerte Temperaturverlauf nur mit hohem Aufwand zu modellieren ist. Somit sieht das obige Temperaturmodell vor, lediglich für stationäre Betriebsphasen, insbesondere im stromlosen Fall, eine Temperaturänderung bzw. eine Temperatur für ein Ende der Zeitdauer des stationären Zustands zu modellieren.

Die Anwendung eines solchen vereinfachten Temperaturmodells macht sich zunutze, dass bei herkömmlichen Betriebsweisen von Elektromotoren als Antriebs- oder Stellmotoren stets auch Stillstandsphasen oder Phasen konstanter Last vorkommen. Diese stellen Betriebsfälle dar, die sich durch ein modellbasiert einfach vorhersagbares Verhalten auszeichnen und die entsprechend dem datenbasierten Temperaturmodell ausgewertet werden können. So können bei einem Antriebsmotor für ein Kraftfahrzeug Phasen, an denen das Fahrzeug nach einer Betriebsphase stillsteht, wie beispielsweise an einem Ampelhalt oder in einem Stau, stets zur Plausibilisierung des Temperatursensors genutzt werden. Diese Phasen sind im Betrieb regelmäßig vorkommend, so dass eine entsprechend regelmäßige Plausibilisierung erfolgen kann.

Auch bei einer als Stellmotor verwendeten elektrischen Maschine in einer Arbeitsmaschine sind derartige Stillstandsphasen häufig, so dass auch hier durch regelmäßige Plausibilisierung eine Signaldrift des Temperatursensors frühzeitig erkannt werden kann.

Weiterhin kann das datenbasierte Temperaturmodell ausgebildet sein, um einen elektrischen Strom bei der stationären Last dem modellierten Temperaturwert zuzuordnen, wobei der modellierte Temperaturwert abhängig von dem ersten Temperaturmesswert, der Zeitdauer, der Umgebungstemperatur und dem konstanten elektrischen Strom bestimmt wird.

Gemäß einer Ausführungsform kann das Feststellen eines unplausiblen Temperaturmesswerts durch ein optisches oder akustisches Signal signalisiert werden und/oder die Betriebsart der elektrischen Maschine entsprechend durch Leistungsreduzierung angepasst werden, um ein Überhitzen der Komponente der elektrischen Maschine zu vermeiden.

Gemäß einer Alternative kann das Temperaturmodell in einem Steuergerät für die elektrische Maschine in einem technischen Gerät berechnet werden.

Bei Feststellen eines plausiblen zweiten Temperaturmesswerts kann das datenbasierte Temperaturmodell basierend auf dem ersten Temperaturmesswert, der Zeitdauer, der Umgebungstemperatur und dem zweiten Temperaturmesswert weiter trainiert oder nachtrainiert werden.

Das datenbasierte Temperaturmodell kann als ein probabilistisches Regressionsmodell ausgebildet sein, wobei das weitere Training nur dann durchgeführt wird, wenn an einem durch den ersten Temperaturmesswert, der Zeitdauer und der Umgebungstemperatur bestimmten Datenpunkt ein Konfidenzwert mithilfe des datenbasierten Temperaturmodells ermittelt wird, der geringer ist als ein vorgegebener Konfidenzschwellenwert.

Das Temperaturmodell kann somit in einem Steuergerät für die elektrische Maschine berechnet werden. Insbesondere, wenn als Temperaturmodell ein probabilistisches Regressionsmodell verwendet wird, kann ein weiteres Training zur Verbesserung des Temperaturmodells dann durchgeführt werden, wenn ein Konfidenzwert, der sich aus der Auswertung des probabilistischen Regressionsmodells für eine elektrische Maschine ergibt, einen Konfidenzschwellenwert unterschreitet.

Gemäß einer weiteren Alternative kann das Temperaturmodell in einer gerätefernen Zentraleinheit berechnet werden, die mit einer Vielzahl von technischen Geräten mit den elektrischen Maschinen in Kommunikationsverbindung steht.

Insbesondere kann bei Feststellen eines plausiblen zweiten Temperaturmesswerts in einem der Vielzahl von technischen Geräten das datenbasierte Temperaturmodell basierend auf dem ersten Temperaturmesswert, der Zeitdauer, der Umgebungstemperatur und dem zweiten Temperaturmesswert weiter trainiert oder nachtrainiert werden.

Es kann vorgesehen sein, dass das datenbasierte Temperaturmodell als ein probabilistisches Regressionsmodell ausgebildet ist, wobei das weitere Training nur dann durchgeführt wird, wenn an einem durch den ersten Temperaturmesswert, der Zeitdauer und der Umgebungstemperatur bestimmten Datenpunkt ein Konfidenzwert mithilfe des datenbasierten Temperaturmodells ermittelt wird, der geringer ist als ein vorgegebener Konfidenzschwellenwert.

Das Temperaturmodell kann somit auch extern des technischen Geräts, beispielsweise in einer Cloud, implementiert sein. Insbesondere kann das Temperaturmodell bei einer Implementierung in einer externen Zentraleinheit (Cloud) durch weitere Betriebspunkte einer Vielzahl von gleichartigen technischen Systemen mit elektrischen Maschinen identischen Typs (Bauart) weiter trainiert werden. Insbesondere, wenn als Temperaturmodell ein probabilistisches Regressionsmodell verwendet wird, kann ein weiteres Training zur Verbesserung des Temperaturmodells dann durchgeführt werden, wenn ein Konfidenzwert, der sich aus der Auswertung des probabilistischen Regressionsmodells für eine elektrische Maschine ergibt, einen Konfidenzschwellenwert unterschreitet.

### Kurzbeschreibung der Zeichnungen

Ausführungsformen werden nachfolgend anhand der beigefügten Zeichnungen näher erläutert. Es zeigen:
- Figur 1: eine schematische Darstellung eines technischen Geräts mit einer elektrischen Maschine und einer Steuereinheit;
- Figur 2: eine schematische Darstellung einer elektrischen Maschine mit einem Temperatursensor zur Temperaturüberwachung;
- Figur 3: ein Flussdiagramm zur Veranschaulichung eines Verfahrens zum Betreiben des technischen Geräts;
- Figur 4: ein Diagramm zur Veranschaulichung der Funktion des Temperaturmodells; und
- Figur 5: ein System mit einer Vielzahl gleichartiger technischer Geräte und einer Zentraleinheit zur Durchführung des Verfahrens zur Plausibilisierung einer Temperaturmessung durch einen Temperatursensor in einer elektrischen Maschine.

### Beschreibung von Ausführungsformen

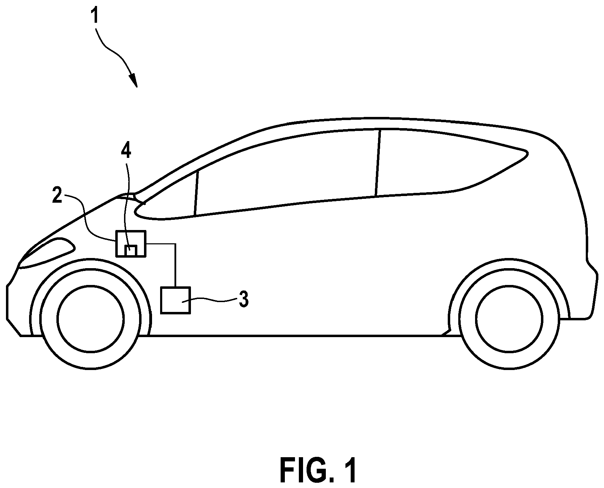

Figur 1 zeigt schematisch ein Kraftfahrzeug 1 als Beispiel für ein technisches Gerät mit einer elektrischen Maschine 2 als Antriebsmotor, die über eine Steuereinheit 3 betrieben wird. Die elektrische Maschine 2 enthält einen Temperatursensor 4, um eine Temperaturüberwachung der elektrischen Maschine 2 auszuführen. Dabei soll mithilfe eines in der Steuereinheit 3 implementierten Verfahrens zur Plausibilisierung einer Komponententemperatur einer Komponente der elektrischen Maschine mit einem Temperaturmodell der gemessene Temperaturwert gegen einen modellierten Temperaturwert abgeglichen werden und bei einer Abweichung ein entsprechender Fehler signalisiert werden.

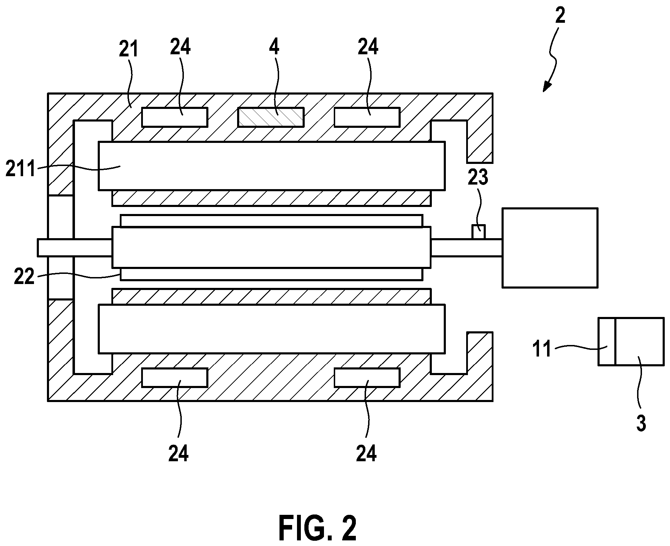

Figur 2 zeigt schematisch eine Querschnittsdarstellung durch eine elektrische Maschine 2 als Teil eines Antriebssystems. Die elektrische Maschine 2 weist einen Stator 21 und einen an einer Welle gelagerten Rotor 22 auf, welche die Komponenten der elektrischen Maschine darstellen. Weiterhin kann der Stator 21 mit Statorspulen 211 versehen sein, die elektrisch über Phasenspannungen und Phasenströme angesteuert werden können. In alternativen Ausführungsformen können auch Rotorspulen und sowohl Stator- als auch Rotorspulen vorgesehen sein.

Die Ansteuerung der elektrischen Maschine 2 erfolgt mithilfe des Steuergeräts 4, das die Ansteuerung der elektrischen Maschine 2 durch Anlegen von Phasenspannungen an die Statorspule 211 entsprechend einem Kommutierungsmuster vorsieht. Das Steuergerät 4 kann daher in an sich bekannter Weise auch eine Leistungstreiberschaltung 5 in Form einer B6-Brückenschaltung oder dergleichen umfassen.

Weiterhin kann der Rotor 22 mit einem Lagesensor 23 gekoppelt sein, der eine Rotorlage des Rotors bezüglich der Anordnung der Statorspulen 211 erfassen kann.

Das Steuergerät 4 betreibt die elektrische Maschine 2 in an sich bekannter Weise durch Vorgabe der Phasenspannungen, um bestimmte Phasenströme so einzustellen, dass ein vorgegebenes Motormoment gestellt wird. Durch die Beaufschlagung mit den Phasenströmen wird Leistung in der elektrischen Maschine 2 umgesetzt, die zu einer Erwärmung von Komponenten der elektrischen Maschine 2 führen kann. Die Erwärmung erfolgt ungleichmäßig in den Komponenten.

In dem Stator 21 sind Kühlmittelkanäle 24 zum Durchleiten von Kühlmittel vorgesehen. Das Kühlmittel wird mit einer im Steuergerät 3 bekannten Strömungsgeschwindigkeit durch die Kühlmittelkanäle 24 geleitet.

Das Steuergerät 4 kann weiterhin ausgebildet sein, ein Temperaturmodell zur Überwachung eines gemessenen Temperaturwerts des Temperatursensors 4 in Echtzeit zu betreiben. Die Überwachung der Funktion des Temperatursensors 4 ist notwendig, da eine nicht ordnungsgemäße Funktion zu einer nicht erkannten Überhitzung von Komponenten der elektrischen Maschine 2 führen kann.

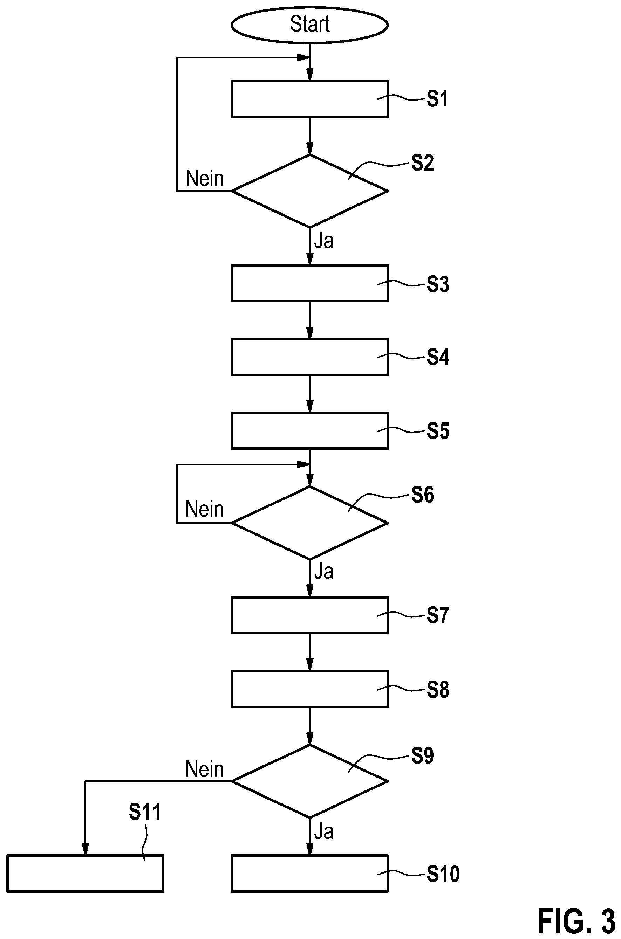

In Figur 3 ist ein Flussdiagramm dargestellt, das das Verfahren zum Plausibilisieren einer Temperaturmessung mit einem Temperatursensor in einer elektrischen Maschine ausführlicher darstellt. Das Verfahren kann beispielsweise in der Steuereinheit 3 des in Figur 1 gezeigten Fahrzeugs als Beispiel für das technische Gerät implementiert sein.

In Schritt S1 wird der Motorstrom der elektrischen Maschine kontinuierlich gemessen und überwacht.

In Schritt S2 wird überprüft, ob die elektrische Maschine 2 stromlos ist oder mit einer konstanten Last, d. h. einem konstanten Motorstrom, betrieben wird. Ist dies der Fall (Alternative: Ja), wird das Verfahren mit Schritt S3 fortgesetzt, anderenfalls (Alternative: Nein) wird zu Schritt S1 zurückgesprungen.

In Schritt S3 wird zunächst abgewartet, bis ein eingeschwungener Zustand eingenommen ist. Die Wartezeit kann beispielsweise zwischen 0 und 2 s, vorzugsweise 1 s betragen.

In Schritt S4 wird eine Temperaturmessung vorgenommen und ein resultierender erster Temperaturmesswert zwischengespeichert.

Weiterhin wird in Schritt S5 eine Umgebungstemperatur erfasst und zwischengespeichert.

In einem nachfolgenden Schritt S6 wird überprüft, ob sich der stationäre Betrieb durch eine zwischenzeitliche Änderung der Stromaufnahme der elektrischen Maschine geändert hat oder eine vorgegebene Maximalzeitdauer seit der Erfassung des ersten Temperaturmesswerts verstrichen ist. Ist dies der Fall (Alternative: Ja), wird das Verfahren mit Schritt S7 fortgesetzt, anderenfalls (Alternative: Nein), wird zum Schritt S6 zurückgesprungen.

In Schritt S7 wird ein zweiter Temperaturmesswert mithilfe des Temperatursensors 4 in einer zweiten Temperaturmessung erfasst sowie eine Zeitdauer zwischen den Erfassungen der Temperaturmesswerte als Zeitdauer der stationären Phase bestimmt und zwischengespeichert.

In Schritt S8 wird nun eine Modellauswertung mit dem Temperaturmodell vorgenommen, das trainiert ist, um den ersten Temperaturmesswert, die Umgebungstemperatur und die Zeitdauer der stationären Phase einem modellierten Temperaturwert zuzuordnen.

Das Temperaturmodell umfasst ein datenbasiertes Modell und kann insbesondere als probabilistisches Regressionsmodell, z. B. in Form eines Gauß-Prozess-Modells, ausgebildet sein. Eine Ausbildung als probabilistisches Regressionsmodell hat den Vorteil, dass neben der Modellausgabe auch ein Konfidenzwert zur Angabe einer Modellierungszuverlässigkeit ausgegeben werden kann.

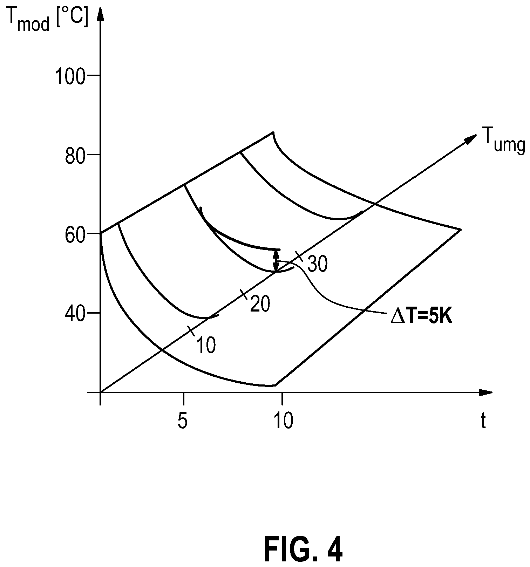

Ein Beispiel für die Funktion des datenbasierten Temperaturmodells ist beispielsweise in Figur 4 dargestellt. Man erkennt die Abhängigkeit des modellierten Temperaturwerts T_{mod} von der Zeitdauer t des stationären Zustands und der Umgebungstemperatur T_{umg} bei einem beispielhaft vorgegebenen ersten Temperaturmesswert T von 60°C. In weiteren Ausführungsformen kann das Temperaturmodell weiterhin eine konstante Last in Form eines Motorstroms als weitere Eingangsdimension berücksichtigen.

Der modellierte Temperaturwert T_{mod} wird in einem nachfolgenden Schritt S9 mit dem zum Ende der Zeitdauer des stationären Betriebs gemessenen zweiten Temperaturmesswert T2 verglichen.

Wird eine Temperaturdifferenz vorzugsweise von mehr als einen vorgegebenen Toleranzschwellenbetrag (von z. B. 1°C) festgestellt (Alternative: Ja), so wird in Schritt S10 eine entsprechende Fehlermeldung signalisiert. Diese kann per optisches oder akustisches Signal an den Fahrer des Fahrzeugs ausgegeben werden oder es kann eine Leistungsreduktion bzw. Leistungsbeschränkung für die elektrische Maschine vorgesehen werden.

Wird keine Temperaturdifferenz festgestellt (Alternative: Nein), so wird das Verfahren mit Schritt S11 fortgesetzt.

In Schritt S11 kann die entsprechende Abfrage des Temperaturmodells aus dem ersten Temperaturmesswert, der Zeitdauer des stationären Betriebs, der Umgebungstemperatur und dem zweiten Temperaturwert zum Ende der Zeitdauer als Trainingsdatensatz zum weiteren Trainieren des datenbasierten Temperaturmodells gespeichert bzw. verwendet werden. Insbesondere kann vorgesehen sein, dass der Trainingsdatensatz nur dann zum weiteren Trainieren des Temperaturmodells verwendet wird, wenn das Temperaturmodell an dem betreffenden Auswertungspunkt aus dem ersten Temperaturmesswert, der Zeitdauer des stationären Betriebs und der Umgebungstemperatur einen Konfidenzwert unter einem vorbestimmten Konfidenzschwellenwert aufweist. Auf diese Weise kann das Temperaturmodell sukzessive weiter verbessert werden.

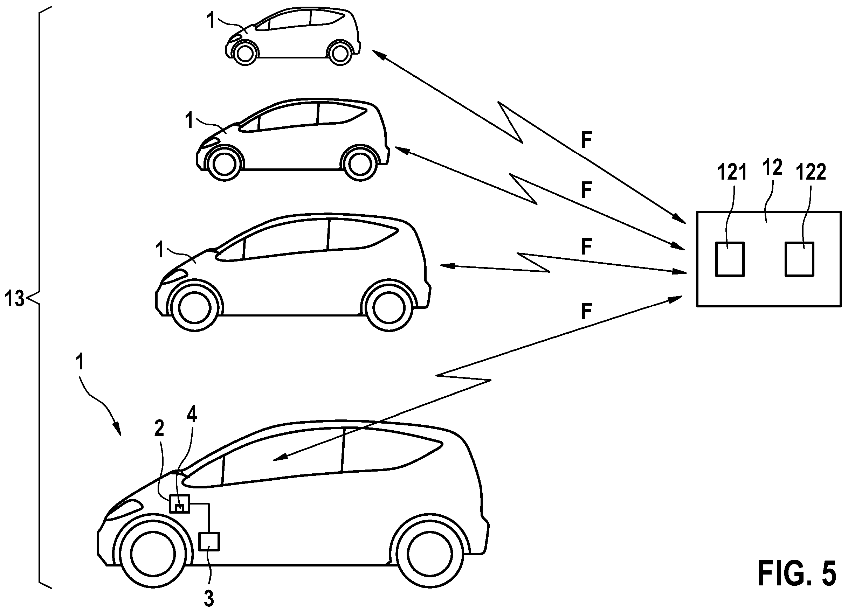

In Figur 5 ist als weitere Ausführungsform ein System dargestellt, bei dem eine Vielzahl von Fahrzeugen 1 einer Fahrzeugflotte 13 den ersten und den zweiten Temperaturmesswert, die Zeitdauer und die Umgebungstemperatur an eine Zentraleinheit 12 in Form von Betriebsdaten F überträgt, sobald diese aus einer Messung vorliegen. Die Zentraleinheit 12 weist eine Datenverarbeitungseinheit 121, in der die Auswertung des Temperaturmodells ausgeführt werden kann, und eine Datenbank 122 zum Speichern von Datenpunkten, Modellparametern, Zuständen und dergleichen auf.

Das System dient zum Sammeln von Flottendaten in der Zentraleinheit 12 sowie zur Plausibilisierung eines zweiten Temperaturmesswerts und Erstellung des datenbasierten Temperaturmodells. Dazu werden die entsprechenden Betriebsgrößen von jedem der Fahrzeuge 1 an die Zentraleinheit 12 übermittelt, wenn ein stationärer Zustand festgestellt worden ist. Durch die Abfrage des Temperaturmodells basierend auf einer Übermittlung des ersten Temperaturwerts, der Zeitdauer des stationären Betriebs und der Umgebungstemperatur an die Zentraleinheit 12 kann der entsprechende modellierte Temperaturwert an das betreffende Fahrzeug zurückübermittelt werden, so dass im Fahrzeug die Plausibilisierung des zweiten Temperaturmesswerts in oben beschriebener Weise vorgenommen werden kann.

Weiterhin kann, wenn wie oben beschrieben der zweite Temperaturwert zum Ende der stationären Zeitdauer ebenfalls an die Zentraleinheit 12 übermittelt wird, eine entsprechende Plausibilisierung auch in der Zentraleinheit 12 vorgenommen werden. Wird dort festgestellt, dass der entsprechende Temperatursensor in dem übermittelnden Fahrzeug nicht ordnungsgemäß funktioniert, so kann dies in entsprechender Weise signalisiert werden und an das Fahrzeug kommuniziert werden. Wird jedoch festgestellt, dass der entsprechende Temperatursensor ordnungsgemäß funktioniert, so kann der aufgezeichnete Datensatz aus den Größen des ersten Temperaturwerts, der Zeitdauer des stationären Betriebs und der Umgebungstemperatur als Trainingsdatensatz für ein weiteres Training des Temperaturmodells in der Zentraleinheit 12 verwendet werden. Auf diese Weise kann eine Vielzahl gleichartiger Geräte bzw. Fahrzeuge zur Weiterbildung des Temperaturmodells verwendet werden.

## Patentansprüche

1. Verfahren zum Plausibilisieren einer Temperaturmessung eines Temperatursensors (4) an einer Komponente (21, 22) einer elektrischen Maschine (2) in einem technischen Gerät (1), wobei das Verfahren ist **gekennzeichnet durch** die folgenden Schritte:
- Überwachen (S1) eines Stroms in der elektrischen Maschine (2);
- bei Feststellen eines Betriebs mit stationärer Last, Bereitstellen (S4) eines ersten Temperaturmesswerts einer Temperatur der Komponente (21, 22) der elektrischen Maschine (2), der Zeitdauer des Betriebs mit stationärer Last und einer Umgebungstemperatur;
- Erfassen (S7) eines zweiten Temperaturmesswerts zu einem Ende des Betriebs mit stationärer Last;
- Bestimmen (S8) eines modellierten Temperaturwerts (T_{mod}) mithilfe eines datenbasierten Temperaturmodells abhängig von dem ersten Temperaturmesswert, der Zeitdauer und der Umgebungstemperatur, wobei das Temperaturmodell trainiert ist, um den ersten Temperaturmesswert, die Zeitdauer und die Umgebungstemperatur einem modellierten Temperaturwert (T_{mod}) zuzuordnen;
- Plausibilisieren (S9) des zweiten Temperaturmesswerts mit dem modellierten Temperaturwert,
wobei ein Betrieb mit stationärer Last festgestellt wird, wenn ein Strom in oder aus der elektrischen Maschine (2) für eine vorbestimmte Mindestzeitdauer und für eine vorbestimmte Maximalzeitdauer konstant ist oder um nicht mehr als einem vorbestimmten Toleranzbetrag von einem Mittelwert des Stroms während der Zeitdauer abweicht.

2. Verfahren nach Anspruch 1, wobei das datenbasierte Temperaturmodell weiterhin ausgebildet ist, um einen elektrischen Strom bei der stationären Last dem modellierten Temperaturwert (T_{mod}) zuzuordnen, wobei der modellierte Temperaturwert (T_{mod}) abhängig von dem ersten Temperaturmesswert, der Zeitdauer, der Umgebungstemperatur und dem konstanten elektrischen Strom bestimmt wird.

3. Verfahren nach einem der Ansprüche 1 bis 2, wobei das Feststellen eines unplausiblen Temperaturmesswerts durch ein optisches oder akustisches Signal signalisiert wird und/oder die Betriebsart der elektrischen Maschine (2) entsprechend durch Leistungsreduzierung angepasst wird, um ein Überhitzen der Komponente (21, 22) der elektrischen Maschine (2) zu vermeiden.

4. Verfahren nach einem der Ansprüche 1 bis 3, wobei das Temperaturmodell in einem Steuergerät (3) für die elektrische Maschine (2) in einem technischen Gerät (1) berechnet wird.

5. Verfahren nach Anspruch 4, wobei bei Feststellen eines plausiblen zweiten Temperaturmesswerts das datenbasierte Temperaturmodell basierend auf dem ersten Temperaturmesswert, der Zeitdauer, der Umgebungstemperatur und dem zweiten Temperaturmesswert weiter trainiert oder nachtrainiert wird.

6. Verfahren nach Anspruch 5, wobei das datenbasierte Temperaturmodell als ein probabilistisches Regressionsmodell ausgebildet ist, wobei das weitere Training nur dann durchgeführt wird, wenn an einem durch den ersten Temperaturmesswerts, der Zeitdauer und der Umgebungstemperatur bestimmten Datenpunkt ein Konfidenzwert mithilfe des datenbasierten Temperaturmodells ermittelt wird, der geringer ist als ein vorgegebener Konfidenzschwellenwert.

7. Verfahren nach einem der Ansprüche 1 bis 3, wobei das Temperaturmodell in einer gerätefernen Zentraleinheit (12) berechnet wird, die mit einer Vielzahl von technischen Geräten (1) mit den elektrischen Maschinen in Kommunikationsverbindung steht.

8. Verfahren nach Anspruch 7, wobei bei Feststellen eines plausiblen zweiten Temperaturmesswerts in einem der Vielzahl von technischen Geräten (1) das datenbasierte Temperaturmodell basierend auf dem ersten Temperaturmesswert, der Zeitdauer, der Umgebungstemperatur und dem zweiten Temperaturmesswert weiter trainiert oder nachtrainiert wird.

9. Verfahren nach Anspruch 8, wobei das datenbasierte Temperaturmodell als ein probabilistisches Regressionsmodell ausgebildet ist, wobei das weitere Training nur dann durchgeführt wird, wenn an einem durch den ersten Temperaturmesswerts, der Zeitdauer und der Umgebungstemperatur bestimmten Datenpunkt ein Konfidenzwert mithilfe des datenbasierten Temperaturmodells ermittelt wird, der geringer ist als ein vorgegebener Konfidenzschwellenwert.

10. Vorrichtung zur Durchführung eines der Verfahren nach einem der Ansprüche 1 bis 9.

11. Computerprogrammprodukt, umfassende Befehle, die bei der Ausführung des Programms durch einen Computer diesen veranlassen, die Schritte des Verfahrens nach einem der Ansprüche 1 bis 9 auszuführen.

12. Maschinenlesbares Speichermedium, umfassend Befehle, die bei der Ausführung durch einen Computer diesen veranlassen, die Schritte des Verfahrens nach einem der Ansprüche 1 bis 9 auszuführen.

## Claims

1. Method for checking the plausibility of a temperature measurement of a temperature sensor (4) on a component (21, 22) of an electric machine (2) in a technical device (1), wherein the method is **characterized by** the following steps:
- monitoring (S1) a current in the electric machine (2);
- when a steady-state load operation is detected, providing (S4) a first temperature measured value of a temperature of the component (21, 22) of the electric machine (2), the duration of the steady-state load operation and an ambient temperature;
- recording (S7) a second temperature measured value at the end of the steady-state load operation;
- determining (S8) a modelled temperature value (T_{mod}) using a data-based temperature model on the basis of the first temperature measured value, the duration and the ambient temperature, wherein the temperature model is trained to assign the first temperature measured value, the duration and the ambient temperature to a modelled temperature value (T_{mod});
- checking the plausibility (S9) of the second temperature measured value using the modelled temperature value,
wherein steady-state load operation is detected when a current in or out of the electric machine (2) is constant for a predetermined minimum duration and for a predetermined maximum duration, or deviates by no more than a predetermined tolerance amount from an average value of the current during the duration.

2. Method according to Claim 1, wherein the data-based temperature model is furthermore formed to assign an electric current at steady-state load to the modelled temperature value (T_{mod}), wherein the modelled temperature value (T_{mod}) is determined on the basis of the first temperature measured value, the duration, the ambient temperature and the constant electric current.

3. Method according to either of Claims 1 and 2, wherein the detection of an implausible temperature measured value is signalled by a visual or audible signal and/or the operating mode of the electric machine (2) is adjusted accordingly by way of power reduction in order to avoid overheating of the component (21, 22) of the electric machine (2).

4. Method according to one of Claims 1 to 3, wherein the temperature model is calculated in a control device (3) for the electric machine (2) in a technical device (1).

5. Method according to Claim 4, wherein, when a plausible second temperature measured value is detected, the data-based temperature model is further trained or retrained based on the first temperature measured value, the duration, the ambient temperature and the second temperature measured value.

6. Method according to Claim 5, wherein the data-based temperature model is in the form of a probabilistic regression model, wherein the further training is carried out only if a confidence value that is lower than a predefined confidence threshold value is ascertained using the data-based temperature model at a data point determined by the first temperature measured value, the duration, and the ambient temperature.

7. Method according to one of Claims 1 to 3, wherein the temperature model is calculated in a central unit (12) that is remote from the device and that is communicatively connected to a plurality of technical devices (1) comprising the electric machines.

8. Method according to Claim 7, wherein, when a plausible second temperature measured value is detected in one of the plurality of technical devices (1), the data-based temperature model is further trained or retrained based on the first temperature measured value, the duration, the ambient temperature and the second temperature measured value.

9. Method according to Claim 8, wherein the data-based temperature model is in the form of a probabilistic regression model, wherein the further training is carried out only if a confidence value that is lower than a predefined confidence threshold value is ascertained using the data-based temperature model at a data point determined by the first temperature measured value, the duration, and the ambient temperature.

10. Apparatus for carrying out one of the methods according to one of Claims 1 to 9.

11. Computer program product comprising instructions that, when the program is executed by a computer, cause said computer to perform the steps of the method according to one of Claims 1 to 9.

12. Machine-readable storage medium comprising instructions that, when executed by a computer, cause said computer to perform the steps of the method according to one of Claims 1 to 9.

## Revendications

1. Procédé de contrôle de plausibilité d'une mesure de température d'un capteur de température (4) au niveau d'un composant (21, 22) d'une machine électrique (2) dans un appareil technique (1), le procédé étant **caractérisé par** les étapes suivantes :
- surveillance (S1) d'un courant dans la machine électrique (2) ;
- lors de la constatation d'un fonctionnement en charge stationnaire, fourniture (S4) d'une première valeur de mesure de température d'une température du composant (21, 22) de la machine électrique (2), de la durée du fonctionnement en charge stationnaire et d'une température ambiante ;
- détection (S7) d'une deuxième valeur de mesure de température à la fin du fonctionnement en charge stationnaire ;
- détermination (S8) d'une valeur de température modélisée (T_{mod}) à l'aide d'un modèle de température basé sur des données en fonction de la première valeur de mesure de température, de la durée et de la température ambiante, le modèle de température étant entraîné pour attribuer la première valeur de mesure de température, la durée et la température ambiante à une valeur de température modélisée (T_{mod}) ;
- contrôle de la plausibilité (S9) de la deuxième valeur de mesure de température avec la valeur de température modélisée,
un fonctionnement en charge stationnaire étant constaté lorsqu'un courant entrant dans ou sortant de la machine électrique (2) est constant pendant une durée minimale prédéterminée et pendant une durée maximale prédéterminée ou ne s'écarte pas plus que d'une valeur de tolérance prédéterminée d'une valeur moyenne du courant pendant la durée.

2. Procédé selon la revendication 1, le modèle de température basé sur des données étant en outre configuré pour attribuer un courant électrique lors de la charge stationnaire à la valeur de température modélisée (T_{mod}), la valeur de température modélisée (T_{mod}) étant déterminée en fonction de la première valeur de mesure de température, de la durée, de la température ambiante et du courant électrique constant.

3. Procédé selon l'une des revendications 1 à 2, la constatation d'une valeur de mesure de température non plausible étant signalée par un signal visuel ou sonore et/ou le mode de fonctionnement de la machine électrique (2) étant adapté en conséquence par réduction de puissance afin d'éviter une surchauffe du composant (21, 22) de la machine électrique (2).

4. Procédé selon l'une des revendications 1 à 3, le modèle de température étant calculé dans un contrôleur (3) pour la machine électrique (2) dans un appareil technique (1).

5. Procédé selon la revendication 4, avec lequel, lors de la constatation d'une deuxième valeur de mesure de température plausible, le modèle de température basé sur des données est soumis à un entraînement supplémentaire ou un réentraînement sur la base de la première valeur de mesure de température, de la durée, de la température ambiante et de la deuxième valeur de mesure de température.

6. Procédé selon la revendication 5, le modèle de température basé sur des données étant réalisé sous la forme d'un modèle de régression probabiliste, l'entraînement supplémentaire n'étant effectué que si, au niveau d'un point de données déterminé par la première valeur de mesure de température, la durée et la température ambiante, une valeur de confiance qui est inférieure à une valeur de seuil de confiance prédéfinie est déterminée à l'aide du modèle de température basé sur des données.

7. Procédé selon l'une des revendications 1 à 3, le modèle de température étant calculé dans une unité centrale (12) éloignée de l'appareil, laquelle est en liaison de communication avec les machines électriques par une pluralité d'appareils techniques (1).

8. Procédé selon la revendication 7, avec lequel, lors de la constatation d'une deuxième valeur de mesure de température plausible dans l'un de la pluralité d'appareils techniques (1), le modèle de température basé sur des données est soumis à un entraînement supplémentaire ou un réentraînement sur la base de la première valeur de mesure de température, de la durée, de la température ambiante et de la deuxième valeur de mesure de température.

9. Procédé selon la revendication 8, le modèle de température basé sur des données étant réalisé sous la forme d'un modèle de régression probabiliste, l'entraînement supplémentaire n'étant effectué que si, au niveau d'un point de données déterminé par la première valeur de mesure de température, la durée et la température ambiante, une valeur de confiance qui est inférieure à une valeur de seuil de confiance prédéfinie est déterminée à l'aide du modèle de température basé sur des données.

10. Dispositif pour la mise en œuvre du procédé selon l'une des revendications 1 à 9.

11. Programme informatique, comprenant des instructions qui, lors de l'exécution du programme par un ordinateur, amènent celui-ci à exécuter les étapes du procédé selon l'une des revendications 1 à 9.

12. Support de stockage lisible par machine comprenant des instructions qui, lorsqu'elles sont exécutées par un ordinateur, amènent celui-ci à exécuter les étapes du procédé selon l'une des revendications 1 à 9.
